# EUROPÄISCHE PATENTSCHRIFT

(11) **EP 2 242 874 B1**
(45) Veröffentlichungstag und Bekanntmachung des Hinweises auf die Patenterteilung: **11.04.2012**
(21) Anmeldenummer: 08715493.6
(22) Anmeldetag: 14.02.2008
(51) Int. Cl.: C30B 11/00, C30B 29/06

(54) **VORRICHTUNG UND VERFAHREN ZUR HERSTELLUNG VON KRISTALLINEN KÖRPERN DURCH GERICHTETE ERSTARRUNG**
DEVICE AND METHOD FOR PREPARING CRYSTALLINE BODIES BY DIRECTIONAL SOLIDIFICATION
DISPOSITIF ET PROCÉDÉ DE FABRICATION DE CORPS CRISTALLINS PAR SOLIDIFICATION DIRECTIONNELLE

(43) Veröffentlichungstag der Anmeldung: 27.10.2010
(73) Patentinhaber: Fraunhofer-Gesellschaft zur Förderung der angewandten Forschung e.V., 80686 München (DE); Deutsche Solar GmbH, 09599 Freiberg (DE)
(72) Erfinder: REIMANN, Christian, 91086 Aurachtal (DE); FRIEDRICH, Jochen, 90542 Eckental (DE); DIETRICH, Marc, 09603 Grossschirma (DE)
(74) Vertreter: Gagel, Roland
(86) Internationale Anmeldenummer: PCT/DE2008/000275
(87) Internationale Veröffentlichungsnummer: WO 2009/100694

(56) Entgegenhaltungen:
- EP-A- 0 939 146
- EP-A- 1 384 538
- WO-A-2006/104107
- DE-A1-102006 017 622

## Beschreibung

### Technisches Anwendungsgebiet

Die Erfindung betrifft eine Vorrichtung zur Herstellung von kristallinen Körpern durch gerichtete Erstarrung, die einen Schmelzofen mit einer Heizkammer umfasst, in der wenigstens eine Auflagefläche für einen Schmelztiegel und wenigstens eine über der Auflagefläche angeordnete Gasspülungseinrichtung mit einem der Auflagefläche zugewandten Gasauslass ausgebildet sind. Die Erfindung betrifft auch ein Verfahren zur Herstellung von kristallinen Körpern durch gerichtete Erstarrung unter Einsatz der Vorrichtung.

Für die Massivkristallzüchtung von Siliziumkristallen sind neben der Züchtung von monokristallinem Silizium nach dem Czochralski-Verfahren und dem Floating-Zone-Verfahren auch mehrere etablierte Verfahren zur Herstellung von multikristallinem Silizium bekannt, die alle nach dem Prinzip der gerichteten Erstarrung ablaufen. Bei der Herstellung kristalliner Körper durch gerichtete Erstarrung wird der Rohstoff zunächst aufgeschmolzen und anschließend in einem Tiegel durch kontrollierte Wärmeabfuhr gerichtet von unten nach oben erstarrt. Dieses Herstellungsverfahren liefert multikristallines Material bspw. für die Herstellung von Solarzellen auf Siliziumbasis. Außerdem wird das Verfahren unter Ausnutzung des Segregationseffektes auch zur Aufreinigung von metallurgischem Silizium eingesetzt.

### Stand der Technik

Bei der Herstellung von multikristallinen Siliziumblöcken durch gerichtete Erstarrung kann es jedoch zur erhöhten Kohlenstoff- und Sauerstoffkonzentrationen im multikristallinen Material kommen. Diese resultieren aus der unkontrollierten Kontamination durch Stoffe aus Ofeneinbauten, dem Schmelztiegel und dem Siliziumrohstoff. So kann bereits vor dem Kristallisationsprozess durch das Handling des Ausgangsmaterials beim Lagern und Einbau in die Kristallisationsanlage eine unkontrollierte Kontamination durch Adhäsion von kohlenstoff- und sauerstoffhaltigen Phasen an der Rohstoffoberfläche stattfinden. Weiterhin besteht das Innere von heute verfügbaren Kristallisationsanlagen überwiegend aus Einbauten aus Graphit, wie Stütztiegel, Heizer oder Isolationsmaterialien. Deshalb gerät Kohlenstoff in Form von Oxidationsprodukten des Graphits zwangsläufig und unkontrolliert in Kontakt mit dem Rohstoff bzw. der Schmelze und schließlich in das erstarrte Silizium. Der Transport der kohlenstoffhaltigen Spezies zum Rohstoff bzw. zur Schmelze erfolgt dabei vor allem über die Gasphase innerhalb der Vorrichtung. Eine weitere Kontaminationsquelle für Kohlenstoff und Sauerstoff ist der Schmelztiegel und dessen Si₃N₄-Beschichtung. Der Eintrag der Fremdstoffe erfolgt hier über den Kontakt mit der Schmelze durch Anlösen und Partikelerosion oder durch Diffusion aus dem Tiegelmaterial.

Kommt es im Siliziummaterial zu einer erhöhten Kontamination von Kohlenstoff und Sauerstoff, so bilden sich bei Überschreiten der Löslichkeitsgrenze in der Schmelze bzw. im multikristallinen Festkörper sauerstoff- und kohlenstoffhaltige Einschlüsse bzw. Ausscheidungen. Diese beeinflussen die Verwendbarkeit des multikristallinen Siliziums zur Herstellung von Solarzellen, da Kohlenstoff und Sauerstoff im multikristallinen Silizium die späteren Solarzelleneigenschaften positiv bzw. negativ beeinflussen können. Es ist deshalb erforderlich, den Kohlenstoff- und Sauerstoffgehalt bei der gerichteten Erstarrung möglichst gut zu kontrollieren.

Eine bekannte Möglichkeit, die Kohlenstoff- und Sauerstoffkonzentration im Silizium zu beeinflussen, besteht darin, eine geeignete Gasströmung über der Schmelzoberfläche zu realisieren, über die kohlenstoff- und sauerstoffhaltige Stoffe abtransportiert werden. So ist es bei der Czochralski Einkristallzüchtung von Silizium bekannt, dass über eine Gasspülung einkristallines Siliziummaterial mit einem definierten Kohlenstoffgehalt erzeugt werden kann. Aus WO 2006/104107 A sind ein Verfahren und eine Vorrichtung zur gerichteten Erstarrung von Siliziumschmelzen bekannt. Oberhalb des die Schmelze enthaltenden Tiegels ist ein Gasrohr vorgesehen, durch das ein Argonstrom fließt, um CO abzuführen, welches aus Kohlenstoffverunreinigungen stammt. Weiterhin beeinflusst eine definierte Gasspülung bei der Herstellung von Siliziumeinkristallen nach dem Czochralski-Verfahren auch das Abdampfen von SiO über der Silizium-Schmelzoberfläche und damit den Sauerstoffgehalt im Kristall.

Die Nutzung einer Gasspülung zur Beeinflussung des Kohlenstoff- und Sauerstoffgehaltes im späteren kristallinen Körper ist aus EP 0 939 146 A (Korrespondierend zu US 6 378 835 B1) auch bei der Herstellung von multikristallinem Silizium durch gerichtete Erstarrung bekannt. Bei dem Verfahren dieser Druckschrift wird ein Schmelzofen mit einer Gasspülungseinrichtung mit einem zentralen, unbeweglichen Rohr eingesetzt, das oberhalb der Schmelzoberfläche positioniert ist.

Gasspülungseinheiten mit Gaszuführungen, die weit von der Schmelzoberfläche entfernt sind, bergen jedoch die Gefahr, dass sich nicht über der gesamten Schmelzoberfläche eine nach außen gerichtete Gasströmung einstellt. Dieses Strömungsmuster ist jedoch für einen effizienten Abtransport der Verunreinigungen notwendig und verhindert, dass Kohlenstoff und Sauerstoff aus anderen Komponenten des Schmelzofens an die Schmelze heran transportiert werden. Es kann bei einem zu großen Abstand zu Rückströmeffekten kommen, wodurch wiederum Kohlenstoff oder Sauerstoff an die Oberfläche der Schmelze heran transportiert werden und in die Schmelze gelangen können. Weiterhin sind durch das große Gasvolumen über der Schmelzoberfläche die erreichbaren Gasgeschwindigkeiten und damit die Effektivität des Abtransportes der Verunreinigungen gering.

### Darstellung der Erfindung

Die Aufgabe der vorliegenden Erfindung besteht darin, eine Vorrichtung sowie ein Verfahren zur Herstellung von kristallinen Körpern durch gerichtete Erstarrung anzugeben, bei denen der Abtransport von kohlenstoff- und sauerstoffhaltigen Verunreinigungen von der Schmelzoberfläche effektiver und kontrollierbarer durchgeführt werden kann.

### Die Aufgabe wird mit der Vorrichtung gemäß den

Patentansprüchen 1 und 2 sowie mit dem Verfahren gemäß Patentanspruch 10 gelöst. Vorteilhafte Ausgestaltungen der Vorrichtung sowie des Verfahrens sind Gegenstand der abhängigen Patentansprüche oder lassen sich der nachfolgenden Beschreibung sowie den Ausführungsbeispielen entnehmen.

Die vorgeschlagene Vorrichtung gemäß einer ersten Alternative umfasst in bekannter Weise einen Schmelzofen mit einer Heizkammer, in der wenigstens eine Auflagefläche für einen Schmelztiegel, der eine Seitenwand und einen Boden aufweist, und wenigstens eine über der Auflagefläche angeordnete Gasspülungseinrichtung mit einem der Auflagefläche zugewandten Gasauslass ausgebildet sind. Die Vorrichtung zeichnet sich dadurch aus, dass der Gasauslass durch eine oder mehrere Öffnungen in einer unteren Stempelfläche eines stempelförmigen Körpers gebildet ist, der eine an eine Innenform des Schmelztiegels angepasste Geometrie aufweist, die ein zumindest teilweises Einführen des stempelförmigen Körpers in den Schmelztiegel mit einem seitlichen Abstand zu der Seitenwand des Schmelztiegels ermöglicht. Die Vorrichtung zeichnet sich weiterhin dadurch aus, dass die Gasspülungseinrichtung und/oder die Auflagefläche in einer axialen Richtung verstellbar angeordnet oder montiert sind, um eine Verstellung oder Änderung eines senkrechten Abstandes zwischen der Auflage und dem stempelförmigen Körper zu ermöglichen.

Durch die Verstellbarkeit des Abstandes zwischen dem stempelförmigen Körper der Gasspülungseinrichtung und der Auflagefläche und somit dem Schmelztiegel bzw. der Schmelzoberfläche eines in dem Schmelztiegel geschmolzenem Materials auf der einen Seite und die an
den Schmelztiegel angepasste Geometrie des Stempels auf der anderen Seite lässt sich der Gasauslass relativ nahe über der Schmelzoberfläche positionieren und der Gasfluss auf den Zwischenraum zwischen dem stempelförmigen Körper und der Schmelzoberfläche sowie der Seitenwand des Schmelztiegels konzentrieren. Auf diese Weise werden hohe Gasgeschwindigkeiten über der Schmelze und damit eine hohe Effektivität des Abtransportprozesses erreicht. Hohe Gasgeschwindigkeiten bedingen auch automatisch hohe Scherkräfte an der Schmelzoberfläche, über die die Schmelzkonvektion positiv beeinflusst wird. Die Schmelzkonvektion ist wichtig, da der Kohlenstoff und Sauerstoff in der Schmelze durch die Konvektion an die Schmelzoberfläche heran transportiert werden muss. Das eingeleitete Gas kann über einen geeigneten Gasauslass wieder aus der Anlage geführt werden. Durch die Einstellbarkeit des senkrechten Abstandes zwischen dem stempelförmigen Körper und der Schmelzoberfläche lassen sich somit die Strömungsbedingungen und daraus resultierend der spätere Kohlenstoff- und Sauerstoffgehalt des kristallisierten Materials besser kontrollieren. Da sich die Füllhöhe des Materials im Schmelztiegel während der Prozessierung ändern kann, lässt sich mit der vorgeschlagenen Vorrichtung durch eine Verstellung der Gasspülungseinrichtung und/oder der Auflagefläche ein stets konstanter Abstand zur Schmelzoberfläche einhalten. So ändert sich beim Aufheizen aufgrund der zunächst lockeren Schüttung des Ausgangsmaterials die Füllhöhe, die zudem auch von Charge zu Charge variieren kann. Nach dem Aufschmelzen des Ausgangsmaterials ergibt sich eine geringere Füllhöhe, die sich dann nochmals ändern kann, wenn sog. Nachchargierungseinheiten benutzt und Ausgangsmaterial nachgefüllt wird. Die Vorrichtung ermöglicht auch eine Variation des Abstandes zwischen der unteren Stempelfläche des stempelförmigen Körpers und der Schmelzoberfläche während des Kristallisationsprozesses, falls dies für das gewünschte Herstellungsergebnis, insbesondere für den gewünschten Kohlenstoff- und Sauerstoffgehalt des kristallinen Körpers, erforderlich sein sollte.

Die vorgeschlagene Vorrichtung sowie das vorgeschlagene Verfahren ermöglichen die Einstellung und Aufrechterhaltung eines kritischen Abstandes des Gasauslasses gegenüber der Schmelzoberfläche während eines vollständigen Kristallisationsprozesses und damit die Herstellung von kristallinen Körpern, insbesondere von multikristallinen Siliziumblöcken, mit definierten Kohlenstoff- und Sauerstoffgehalten. Die Konstruktion erlaubt zusätzlich das Antreiben der natürlichen Schmelzbadkonvektion durch die Gasspülung und damit eine homogenere Verteilung von Dotier- und Fremdstoffen, durch die die Materialqualität des gezüchteten kristallinen Körpers zusätzlich verbessert wird. Mit der Vorrichtung lassen sich bspw. multikristalline Siliziumkörper erzeugen, die Kohlenstoffkonzentrationen von < 1 x 10¹⁷ Atomen/cm³ und Sauerstoffkonzentrationen von < 1 x 10¹⁶ Atomen/cm³ aufweisen.

Die vorgeschlagene Vorrichtung gemäß der zweiten Alternative weist die gleichen Vorteile auf, wie sie bereits vorangehend beschrieben wurden. Diese zweite Alternative unterscheidet sich lediglich von der bereits beschriebenen ersten Alternative darin, dass die Gasspülungseinrichtung mehrere nebeneinander angeordnete stempelförmige Körper mit entsprechenden Gasauslassöffnungen aufweist, die in ihrer Gesamtheit an die Geometrie des Schmelztiegels angepasst sind. Eine derartige Ausgestaltung bietet sich vor allem dann an, wenn eine ausgedehnte Schmelzoberfläche aufgrund großer lateraler Abmessungen des Schmelztiegels vorliegt. Die Wirkung des stempelförmigen Körpers der oben beschriebenen Vorrichtung wird dabei auf mehrere nebeneinander angeordnete stempelförmige Körper verteilt, die auch unabhängig voneinander in Richtung der Schmelzoberfläche verstellbar sein können, jedoch in der Regel gemeinsam eingestellt oder bewegt werden.

Der stempelförmige Körper oder die Gruppe aus stempelförmigen Körpern weist dabei vorzugsweise eine Geometrie auf, die beim Einführen des stempelförmigen Körpers bzw. der Gruppe von stempelförmigen Körpern in den Schmelztiegel einen auf allen Seiten gleichen Abstand zur Seitenwand des Schmelztiegels ermöglicht. Vorzugsweise liegt dieser seitliche Abstand bei ≤ 1cm. Die Stempelunterseite ist dabei in der bevorzugten Ausgestaltung eben ausgeführt, so dass auch zur Schmelzoberfläche ein überall konstanter senkrechter Abstand besteht.

Vorzugsweise werden bei der Durchführung des Verfahrens der Gasfluss sowie der Abstand zur Schmelzoberfläche und zur Seitenwand des Schmelztiegels so gewählt oder eingestellt, dass eine laminare Strömung in den Zwischenräumen zwischen dem stempelförmigen Körper und der Schmelze bzw. dem Schmelztiegel erreicht wird. Für unterschiedliche Größen und geometrische Formen von Schmelztiegeln können hierbei unterschiedliche stempelförmige Körper vorgesehen sein, die bei Austausch eines Schmelztiegels gegen einen Schmelztiegel anderer Geometrie ebenfalls an der Gasspülungseinrichtung ausgetauscht werden. Auf diese Weise kann immer ein dem Schmelztiegel angepasster stempelförmiger Körper in der Gasspülungseinrichtung verwendet werden.

Die Gasspülungseinheit besteht hierbei vorzugsweise aus einem graphitfreien Material, um einen Transport von kohlenstoffhaltigem Material über die Gasspülungseinheit zur Schmelzoberfläche zu vermeiden.

Mit der genannten Vorrichtung und dem zugehörigen Verfahren wird es somit ermöglicht, den Kohlenstoff- und Sauerstoffgehalt, der sich im erstarten kristallinen Material findet, während eines vollständigen Züchtungsprozesses über die Gasphase zu kontrollieren. Durch den im Abstand zur Schmelzoberfläche verstellbaren und in einem stempelförmigen Körper ausgebildeten Gasauslass kann eine kritische Höhe über der Schmelze eingestellt und eine Abschirmung gegenüber dem umgebenden Teil der Vorrichtung gewährleistet werden. Durch Zuführung eines definierten Inertgasflusses zu den entsprechenden Prozesszeitpunkten kann ein kontrollierter An- bzw. Abtransport der jeweiligen unerwünschten Stoffe erreicht werden. Eine erhöhte Gasspülmenge wirkt sich dabei zusätzlich auf die natürliche Schmelzbadkonvektion aus. Je nach Strömungsrichtung der natürlichen Konvektion an der Schmelzoberfläche kann durch diese Gasströmung die Strömung in der Schmelze angetrieben oder gebremst werden. Als Folge dieser Gas-Schmelze Wechselwirkung lässt sich eine homogenere radiale Verteilung der Fremd- oder Dotierstoffe innerhalb des kristallinen Körpers erreichen.

Bei der vorgeschlagenen Vorrichtung ist vorzugsweise die Gasspülungseinheit im Abstand zur Schmelzoberfläche verstellbar ausgebildet. Selbstverständlich kann jedoch alternativ oder in Kombination auch die Auflagefläche für den Schmelztiegel in der Höhe verstellbar ausgestaltet werden. Die Verstellung kann hierbei sowohl manuell als auch über einen Antrieb, bspw. einen Motor, bewirkt werden.

Beim Betrieb der Vorrichtung für die Herstellung von kristallinen Körpern lassen sich unterschiedliche Parameter variieren. So kann bspw. der Gasfluss oder der Abstand zur Schmelzoberfläche während des Prozesses verändert werden. Weiterhin können auch unterschiedliche Gase im Verlauf des Züchtungsprozesses zur Gasspülung eingesetzt werden.

Die Vorrichtung und das Verfahren eignen sich sehr vorteilhaft für die Herstellung von multikristallinen Siliziumkörpern, wie sie in Solarzellen Verwendung finden. Selbstverständlich lässt sich die Vorrichtung jedoch auch zur Herstellung von anderen kristallinen Körpern einsetzen, bspw. von einkristallinen Halbleitern oder optischen Kristallen mittels gerichteter Erstarrung. Die Vorrichtung ist auch für die Aufreinigung von metallurgischem Silizium geeignet.

### Kurze Beschreibung der Zeichnungen

Die vorgeschlagene Vorrichtung sowie das zugehörige Verfahren werden nachfolgend anhand von Ausführungsbeispielen in Verbindung mit den Zeichnungen nochmals kurz erläutert. Hierbei zeigen:
- Fig. 1: ein Beispiel für eine Ausgestaltung der Vorrichtung in schematisierter Darstellung;
- Fig. 2: ein weiteres Beispiel für eine Ausgestaltung der Vorrichtung in schematischer Darstellung;
- Fig. 3: die Kohlenstoff- und Sauerstoffkonzentration über die erstarrte Blockhöhe von multikristallinem Silizium in Abhängigkeit von der verwendeten Gasspülmenge x;
- Fig. 4: die Kohlenstoffkonzentration über die erstarrte Blockhöhe von multikristallinem Silizium in Abhängigkeit der verwendeten Gasspülungseinrichtung;
- Fig. 5: die Strömungsgeschwindigkeit des Schmelzbades in Abhängigkeit der verwendeten Gasspülmenge; und
- Fig. 6: eine numerisch ermittelte Durchbiegung der Phasengrenze flüssig-fest in Abhängigkeit der verwendeten Gasspülmenge.

### Wege zur Ausführung der Erfindung

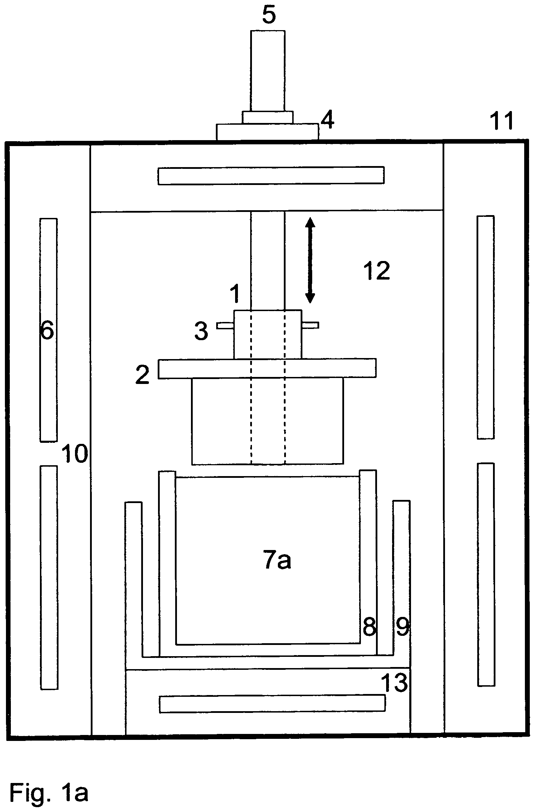

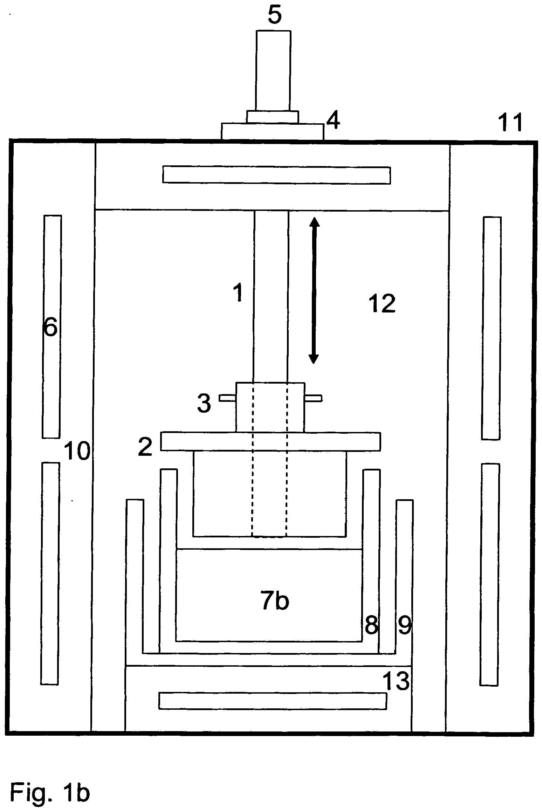

Figur 1 zeigt in schematischer Darstellung ein erstes Beispiel für eine Ausgestaltung der vorgeschlagenen Vorrichtung. Figur 1a stellt hierbei einen Zustand vor und während des Aufschmelzprozesses, Figur
1b einen Zustand während des Kristallisationsprozesses dar. Die Vorrichtung dieses Ausführungsbeispiels unterscheidet sich im Wesentlichen durch die Ausgestaltung der Gasspülungseinheit von bekannten Vorrichtungen. Die Vorrichtung umfasst den Schmelzofen 11 mit integrierten Heizelementen 6, dem Isolationsmaterial 10 und einer Heizkammer 12, in der eine Auflagefläche 13 für den Schmelztiegel 8 angeordnet ist. Die graphitfreie Gasspülungseinrichtung umfasst ein Rohr 1 aus Aluminiumoxid, an dem über eine Drahtsteckverbindung 3, z.B. aus einem Molybdän-Lanthan-Draht, ein Stempel 2 aus Aluminiumoxid angebracht ist. Die Gasspülungseinrichtung ist in die Heizkammer 12 des Schmelzofens 11 eingebracht und an einer zentralen Öffnung im Deckel des Schmelzofens mit diesem verschraubt. Die im vorliegenden Beispiel gewählte Quetschverschraubung 4 des Rohres 1 mit dem Deckel des Schmelzofens erlaubt es, die axiale Position des Stempels 2 bei unterschiedlichen Anlagendrücken und während des gesamten Prozesses definiert zu variieren, wie dies in der Figur 1 mit dem Doppelpfeil angedeutet ist. Hierbei kann es nicht zu einer Wechselwirkung der Anlagenatmosphäre in der Heizkammer 12 mit der äußeren Atmosphäre kommen, da die Quetschverschraubung gasdicht ist. Über eine externe Gaszuleitung 5, die mit dem Aluminiumoxid-Rohr 1 am oberen Ende verbunden ist, kann Spülgas im Zentrum der Heizkammer 12 in definierter Höhe über dem Siliziumrohstoff oder der Siliziumschmelze eingeleitet werden. Der Siliziumrohstoff 7a wird dabei in den Schmelztiegel 8 gegeben, der im vorliegenden Beispiel aus Quarzglas besteht und mit einer Si₃N₄-Beschichtung versehen ist. Der Schmelztiegel 8 ist in einem Graphit-Stütztiegel 9 angeordnet, der auf der Auflagefläche 13 der Heizkammer 12 steht.

Der Stempel 2 ist an die Geometrie des Schmelztiegels 8 derart angepasst, dass sich dieser Stempel 2 unter Einhaltung eines Abstandes zu der Seitenwand des Schmelztiegels zumindest teilweise in diesen einführen lässt. An der Stempelunterseite ist eine Gasauslassöffnung für das zugeführte Spülgas ausgebildet, wie dies mit den gestrichelten Linien in der Figur angedeutet ist. Die Stempelgeometrie wird bei einem Schmelztiegel mit runder Querschnittsfläche rund, bei einem Schmelztiegel mit eckiger Querschnittsfläche entsprechend eckig ausgebildet. Im Abstand von der Stempelunterseite weist der Stempel der Figur 1a einen umlaufenden Vorsprung auf, durch den der obere Rand des Schmelztiegels 8 vollständig abgedeckt werden kann.

Durch diese Ausgestaltung der Gasspülungseinrichtung lässt sich über die externe Gaszuleitung 5 das Spülgas in definierter Höhe über dem Siliziumrohstoff 7a oder der Siliziumschmelze 7b (vgl. Fig. 1b) einleiten. Weiterhin kann über einen nicht dargestellten peripheren Massenflussregler die Gasflussmenge, die durch das Rohr 1 und den Stempel 2 in den Schmelztiegel 8 gelangt, eingestellt werden. Entscheidend für eine optimale Wirkungsweise der Gasspülungseinrichtung ist die angepasste Form des eingesetzten Stempels 2. Um eine optimale Wechselwirkung der eingesetzten Gasphase mit dem Rohstoff oder der Schmelze zu erhalten, ist ein kritischer Abstand zu dessen bzw. deren Oberfläche zu realisieren. Mit der vorgeschlagenen Ausgestaltung der Gasspülungseinrichtung mit angepasster Stempelgeometrie und verstellbarem Abstand ist es möglich, zu jedem Prozesszeitpunkt diesen kritischen Abstand zwischen Stempelunterseite und Oberfläche von Rohstoff oder Schmelze einzuhalten. Deshalb ist es auch möglich, während des Aufschmelzens des Siliziumrohstoffs im Schmelztiegel die Änderung der Füllstandshöhe vom locker geschütteten Rohstoff 7a zur flüssigen Schmelze 7b durch die axiale Verschiebung des Stempels 2 auszugleichen. Der Stempel 2 wird hierbei in den Schmelztiegel 8 gefahren, ohne jedoch mit dem Schmelztiegel 8 oder der Schmelze in Kontakt zu kommen. Dies ist in Figur 1b dargestellt, bei der der Stempel 2 tiefer in den Schmelztiegel 8 abgesenkt wurde, um einen konstanten Abstand zu der durch das Aufschmelzen abgesunkenen Oberfläche einzuhalten. Die Ausgestaltung der Gasspülungseinheit, insbesondere des Rohres 1, des Stempels 2 sowie der Gaszuführung 5, aus einem graphitfreien Material trägt zur effizienten Wirkungsweise der Gasspülungseinheit bei.

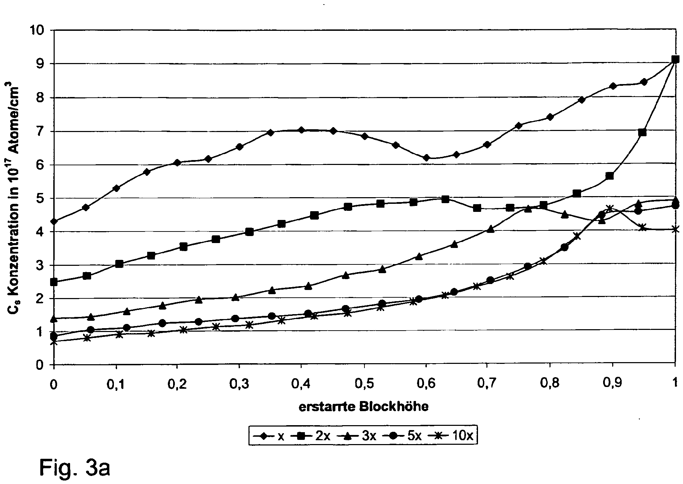

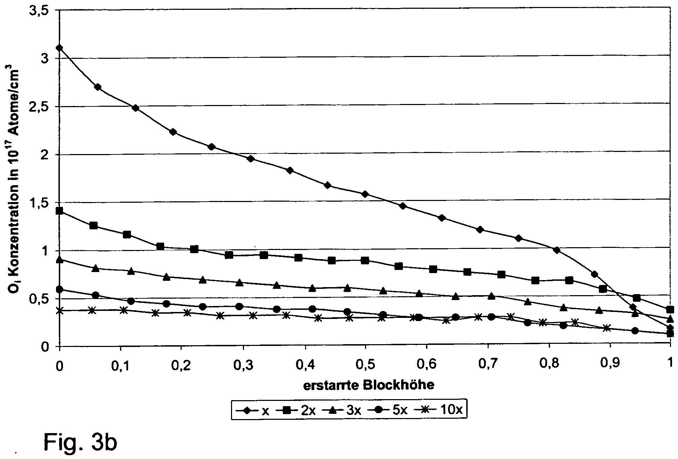

Ein weiterer wichtiger Parameter für eine effektive Wirkungsweise der Gasspülungseinheit ist die Gasspülmenge. Sie beeinflusst die Menge an kohlenstoff- und sauerstoffhaltigen Spezies, die zum Rohstoff und der Schmelze an- bzw. von diesen abtransportiert werden. Als entscheidender Parameter wird hierbei das Verhältnis von Gasvolumen im Schmelztiegel unterhalb des Stempels 2 zur eingeleiteten Gasspülmenge gesehen. Die Figuren 3a und 3b zeigen hierbei den Kohlenstoff- und Sauerstoffgehalt in dem mit der Vorrichtung hergestellten multikristallinen Silizium in Abhängigkeit von der verwendeten Gasspülmenge x. Aus den angeführten Messergebnissen geht eindeutig hervor, dass durch Einsatz der Gasspülungseinheit mit einer erhöhten Gasspülmenge eine signifikante Erniedrigung des Kohlenstoff- und Sauerstoffgehaltes erreicht werden kann. Damit ist je nach Gasspülmenge die Möglichkeit gegeben, die gewünschte Konzentration der entsprechenden Fremdstoffe im Festkörper gezielt einzustellen.

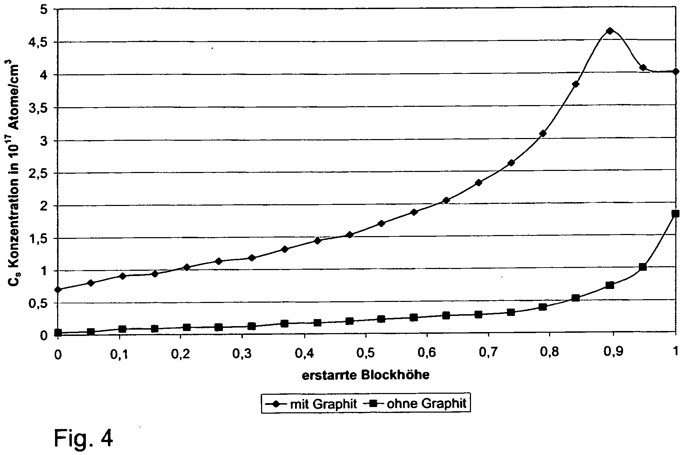

Figur 4 zeigt den Einfluss des Materials der Gasspülungseinrichtung auf das Ergebnis der Kristallzüchtung. Hierbei wurde in einem Fall eine Gasspülungseinheit aus einem graphitfreien Material und im anderen Fall eine Gasspülungseinheit aus einem Graphit enthaltenen Material gewählt. Der deutliche Unterschied in der Kohlenstoffkonzentration des gezüchteten multikristallinen Siliziumkörpers ist aus der Figur deutlich ersichtlich.

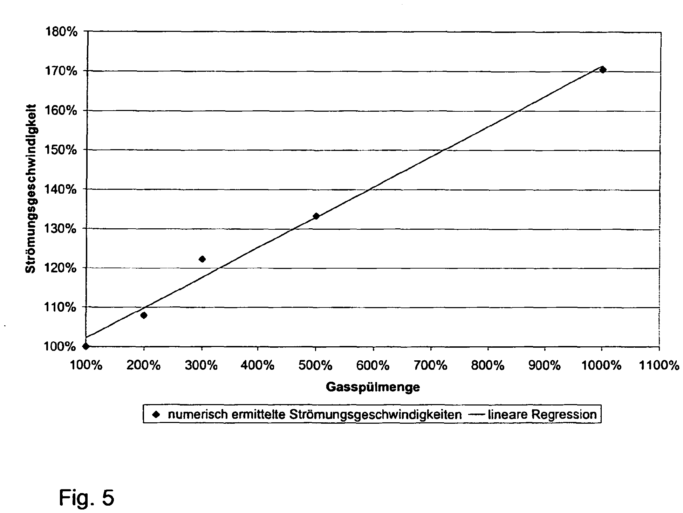

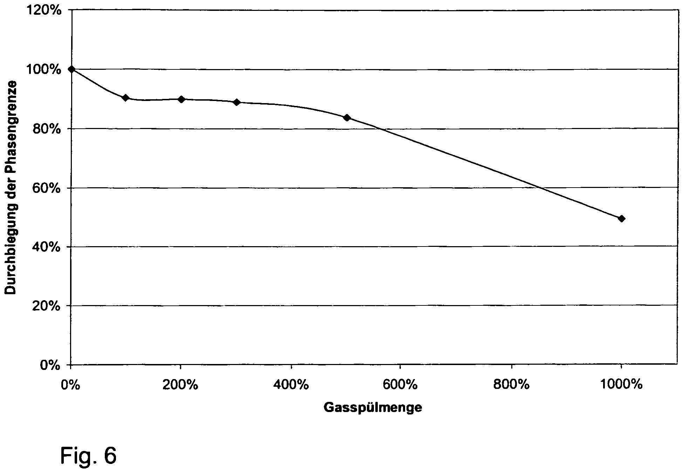

Durch die vorgeschlagene Ausgestaltung der Gasspülungseinrichtung mit einem stempelförmigen Körper, der nahe an der Schmelzoberfläche positioniert werden kann, lässt sich mit dem Gasfluss auch die Konvektion im Schmelzbad positiv beeinflussen. Figur 5 zeigt hierbei, dass eine Erhöhung der Gasspülmenge eine Zunahme der Strömungsgeschwindigkeiten innerhalb der Schmelze zur Folge hat. Dies führt, wie in Figur 6 gezeigt, zu einer Verringerung der Durchbiegung der Phasengrenze fest-flüssig und damit zu einer homogeneren radialen Verteilung von Dotier- und Fremdstoffen innerhalb des multikristallinen Siliziummaterials.

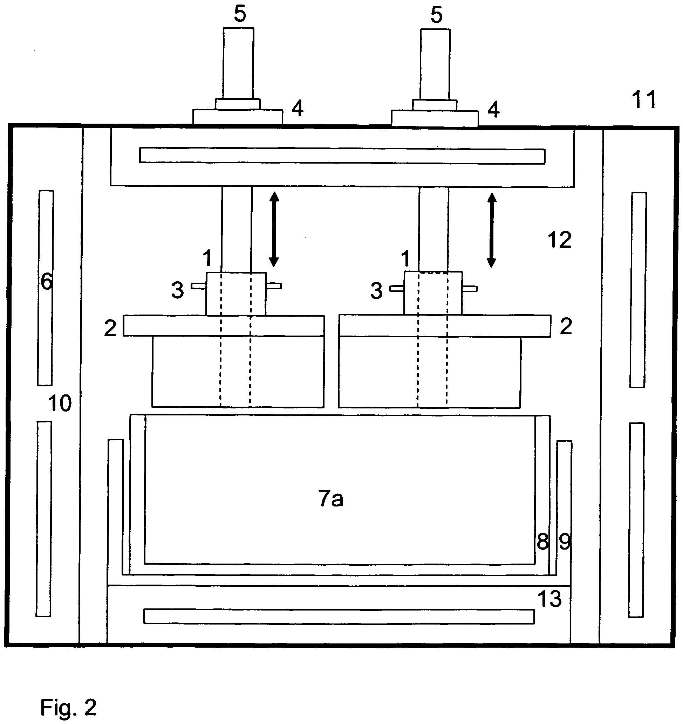

Figur 2 zeigt schließlich noch ein weiteres Beispiel einer Ausgestaltung der vorgeschlagenen Vorrichtung, bei der in diesem Beispiel zwei Stempel 2 nebeneinander in der Gasspülungseinrichtung eingesetzt werden. Der Schmelztiegel 8 kann hierbei bspw. eine langgestreckte rechteckige Form aufweisen, wobei die Querschnittsfläche dieses Schmelztiegels 8 von den beiden Stempeln 2 im Wesentlichen, d. h. bis auf den Zwischenraum zur Seitenwand des Schmelztiegels 8, abgedeckt wird. Die gleichen Komponenten dieser Vorrichtung sind mit den gleichen Bezugszeichen versehen, wie bei der Vorrichtung der Figur 1, so dass auf diese Komponenten aufgrund der gleichen Ausgestaltung und Funktion nicht mehr näher eingegangen wird. In diesem Beispiel sind zwei externe Gaszuführungen 5 vorgesehen, die mit den beiden Rohren 1 verbunden sind. An beiden Rohren 1 ist jeweils ein Stempel 2 befestigt, der einen Gasauslass an der Stempelunterseite aufweist. Beide Stempel 2 sind entsprechend den Doppelpfeilen axial verschiebbar, um den gewünschten Abstand zur Oberfläche des Rohstoffs 7a bzw. der Schmelze einstellen zu können. Die Wirkungsweise dieser Vorrichtung ist identisch der Wirkungsweise der Vorrichtung der Figur 1, wobei hier jeweils beide Stempel 2 simultan verfahren werden. Eine derartige Ausgestaltung ermöglicht den Einsatz von Schmelztiegeln 8 mit größeren lateralen Dimensionen, ohne die Anforderungen an die mechanische Stabilität der Aufhängung der einzelnen Stempel 2 zu erhöhen.

### Bezugszeichenliste

- 1: Rohr
- 2: Stempel
- 3: Drahtsteckverbindung
- 4: Quetschverschraubung
- 5: Gaszuführung
- 6: Heizelement
- 7a: Rohstoff
- 7b: Schmelze
- 8: Schmelztiegel
- 9: Stütztiegel
- 10: Isolation
- 11: Schmelzofen
- 12: Heizkammer
- 13: Auflagefläche

## Patentansprüche

1. Vorrichtung zur Herstellung von kristallinen Körpern mittels gerichteter Erstarrung, die einen Schmelzofen (11) mit einer Heizkammer (12) umfasst, in der wenigstens eine Auflagefläche (13) für einen Schmelztiegel (8), der eine Seitenwand und einen Boden aufweist, und wenigstens eine oberhalb der Auflagefläche (13) angeordnete Gasspülungseinrichtung mit einem der Auflagefläche (13) zugewandten Gasauslass ausgebildet sind,
**dadurch gekennzeichnet,**
**dass** der Gasauslass durch eine oder mehrere Öffnungen in einer unteren Stempelfläche eines stempelförmigen Körpers (2) gebildet ist, der eine an eine Innenform des Schmelztiegels (8) angepasste Geometrie aufweist, die ein zumindest teilweises Einführen des stempelförmigen Körpers (2) in den Schmelztiegel (8) mit einem seitlichen Abstand zu der Seitenwand des Schmelztiegels (8) ermöglicht, und dass die Gasspülungseinrichtung und/oder die Auflagefläche (13) in einer axialen Richtung verstellbar angeordnet oder montiert sind, um eine Änderung eines senkrechten Abstandes zwischen der Auflagefläche (13) und dem stempelförmigen Körper (2) zu ermöglichen.

2. Vorrichtung zur Herstellung von kristallinen Körpern mittels gerichteter Erstarrung, die einen Schmelzofen (11) mit einer Heizkammer (12) umfasst, in der wenigstens eine Auflagefläche (13) für einen Schmelztiegel (8), der eine Seitenwand und einen Boden aufweist, und wenigstens eine über der Auflagefläche (13) angeordnete Gasspülungseinrichtung mit einem der Auflagefläche (13) zugewandten Gasauslass ausgebildet sind, **dadurch gekennzeichnet,**
**dass** der Gasauslass durch eine oder mehrere Öffnungen in unteren Stempelflächen einer Gruppe aus mehreren, nebeneinander angeordneten stempelförmigen Körpern (2) gebildet ist, die eine an eine Innenform des Schmelztiegels (8) angepasste Geometrie aufweist, die ein zumindest teilweises Einführen der Gruppe aus stempelförmigen Körpern (2) in den Schmelztiegel (8) mit einem seitlichen Abstand zu der Seitenwand des Schmelztiegels (8) ermöglicht,
und **dass** die Gasspülungseinrichtung und/oder die Auflagefläche (13) in einer axialen Richtung verstellbar angeordnet oder montiert sind, um eine Änderung eines senkrechten Abstandes zwischen der Auflagefläche (13) und den stempelförmigen Körpern (2) zu ermöglichen.

3. Vorrichtung nach Anspruch 1,
**dadurch gekennzeichnet,**
**dass** der stempelförmige Körper (2) eine Geometrie aufweist, die ein zumindest teilweises Einführen des stempelförmigen Körpers (2) in den Schmelztiegel (8) mit einem auf jeder Seite gleichen seitlichen Abstand zu der Seitenwand ermöglicht.

4. Vorrichtung nach Anspruch 1 oder 3,
**dadurch gekennzeichnet,**
**dass** der stempelförmige Körper (2) in einem Abstand von der unteren Stempelfläche einen umlaufenden seitlichen Vorsprung aufweist der eine Abdeckung eines oberen Randes des Schmelztiegels (8) ermöglicht.

5. Vorrichtung nach Anspruch 2,
**dadurch gekennzeichnet,**
**dass** die Gruppe aus stempelförmigen Körpern (2) eine Geometrie aufweist, die ein zumindest teilweises Einführen der Gruppe aus stempelförmigen Körpern (2) in den Schmelztiegel (8) mit einem auf jeder Seite gleichen seitlichen Abstand zu der Seitenwand ermöglicht.

6. Vorrichtung nach Anspruch 2 oder 5,
**dadurch gekennzeichnet,**
**dass** die stempelförmigen Körper (2) in einem Abstand von der unteren Stempelfläche einen seitlichen Vorsprung aufweisen, der eine Abdeckung eines oberen Randes des Schmelztiegels (8) ermöglicht.

7. Vorrichtung nach einem der Ansprüche 1 bis 6,
**dadurch gekennzeichnet,**
**dass** die untere Stempelfläche eben ausgebildet und parallel zu der Auflagefläche (13) angeordnet ist.

8. Vorrichtung nach einem der Ansprüche 1 bis 7,
**dadurch gekennzeichnet,**
**dass** die Geometrie des stempelförmigen Körpers oder der Gruppe aus stempelförmigen Körpern (2) so gewählt ist, dass der seitliche Abstand zu der Seitenwand des Schmelztiegels (8) s 1cm beträgt.

9. Vorrichtung nach einem der Ansprüche 1 bis 8,
**dadurch gekennzeichnet,**
**dass** die Gasspülungseinrichtung aus einem kohlenstofffreien Material besteht.

10. Verfahren zur Herstellung von kristallinen Körpern mittels gerichteter Erstarrung, insbesondere zur Herstellung von Körpern aus multikristallinem Silizium, in der Vorrichtung nach einem der Ansprüche 1 bis 9, bei dem
- ein Ausgangsmaterial (7a) für die Herstellung der kristallinen Körper in dem Schmelztiegel (8) unter Bildung einer Schmelze (7b) geschmolzen wird,
- die untere(n) Stempelfläche(n) der Gasspülungseinrichtung auf einen Abstand zu einer Oberfläche der Schmelze (7b) bzw. des Ausgangsmaterials (7a) eingestellt wird/werden, der einen Abtransport von unerwünschtem Material von der Oberfläche der Schmelze (7b) bzw. des Ausgangsmaterials (7a) durch Zuführung eines Spülgases über die Gasspülungseinrichtung ermöglicht,
- das Spülgas über die Gasspülungseinrichtung zugeführt wird, um einen Gasfluss über der Oberfläche der Schmelze (7b) bzw. des Ausgangsmaterials (7a) zu erzeugen, und
- die Schmelze (7b) während der Zuführung des Spülgases gerichtet von unten nach oben erstarrt wird.

11. Verfahren nach Anspruch 10,
bei dem der Gasfluss während der gerichteten Erstarrung variiert wird.

12. Verfahren nach Anspruch 10 oder 11,
bei dem der Abstand zwischen der Oberfläche der Schmelze (7b) und der unteren Stempelfläche während der gerichteten Erstarrung variiert wird.

13. Verfahren nach Anspruch 10 oder 11,
bei dem der Abstand zwischen der Oberfläche der Schmelze (7b) und der unteren Stempelfläche während der gerichteten Erstarrung konstant gehalten wird.

14. Verfahren nach einem der Ansprüche 10 bis 13,
bei dem der Abstand zwischen der Oberfläche der Schmelze (7b) und der unteren Stempelfläche sowie der Gasfluss so eingestellt werden, dass sich eine Gasströmung für den Abtransport des unerwünschten Materials von der Oberfläche der Schmelze (7b) über einen Zwischenraum zwischen dem oder den stempelförmigen Körpern (2) und der Seitenwand des Schmelztiegels (8) einstellt.

15. Verfahren nach einem der Ansprüche 10 bis 14,
bei dem der Abstand zwischen der Oberfläche der Schmelze (7b) und der unteren Stempelfläche sowie der Gasfluss so eingestellt werden, dass der Gasfluss eine Strömungsgeschwindigkeit in der Schmelze (7b) beeinflusst.

16. Verfahren nach einem der Ansprüche 10 bis 15,
bei dem der Abstand zwischen der Oberfläche der Schmelze (7b) und der unteren Stempelfläche sowie der Gasfluss so eingestellt werden, dass der Gasfluss einen Grad einer Durchbiegung einer Phasengrenze flüssig-fest in der der Schmelze (7b) beeinflusst.

## Claims

1. A device for producing crystalline bodies by directional solidification, which encompasses a melting furnace (11) with a heating chamber (12), in which are defined at least one supporting surface (13) for a crucible (8) having a lateral wall and floor, and at least one gas purging device arranged over the supporting surface (13) with a gas outlet facing the supporting surface (13), **characterized in that** the gas outlet is formed by one or more openings in a lower plunger surface of a plunger-shaped body (2), which has a geometry adapted to the inner shape of the crucible (8), permitting at least a partial insertion of the plunger-shaped body (2) into the crucible (8) at a lateral distance to the lateral wall of the crucible (8), and that the gas purging device and/or supporting surface (13) are situated or mounted so that they can be adjusted in an axial direction, thereby enabling a change in the perpendicular distance between the supporting surface (13) and plunger-shaped body (2).

2. A device for producing crystalline bodies by directional solidification, which encompasses a melting furnace (11) with a heating chamber (12), in which are defined at least one supporting surface (13) for a crucible (8) having a lateral wall and floor, and at least one gas purging device arranged over the supporting surface (13) with a gas outlet facing the supporting surface (13), **characterized in that** the gas outlet is formed by one or more openings in lower plunger surfaces of a group of several side-by-side plunger-shaped bodies (2), which has a geometry adapted to the inner shape of the crucible (8), permitting at least a partial insertion of the group of plunger-shaped bodies (2) into the crucible (8) at a lateral distance to the lateral wall of the crucible (8), and that the gas purging device and/or supporting surface (13) are situated or mounted so that they can be adjusted in an axial direction, thereby enabling a change in the perpendicular distance between the supporting surface (13) and plunger-shaped body (2).

3. The device according to claim 1, **characterized in that** the plunger-shaped body (2) has a geometry that enables at least a partial insertion of the plunger-shaped body (2) into the crucible (8) at a unilaterally identical distance to the lateral wall.

4. The device according to claim 1 or 3, **characterized in that** the plunger-shaped body (2) has a continuous lateral projection at a distance from the lower plunger surface that makes it possible to cover an upper edge of the crucible (8).

5. The device according to claim 2, **characterized in that** the group of plunger-shaped bodies (2) has a geometry that enables at least a partial insertion of the group of plunger-shaped bodies (2) into the crucible (8) at a unilaterally identical distance to the lateral wall.

6. The device according to claim 2 or 5, **characterized in that** the plunger-shaped bodies (2) have a continuous lateral projection at a distance from the lower plunger surface that makes it possible to cover an upper edge of the crucible (8).

7. The device according to one of claims 1 to 6, **characterized in that** the lower plunger surface is flat and arranged parallel to the supporting surface (13).

8. The device according to one of claims 1 to 7, **characterized in that** the geometry of the plunger-shaped body (2) or group of plunger-shaped bodies (2) is selected in such a way that the lateral distance to the lateral wall of the crucible (8) measures ≤ 1 cm.

9. The device according to one of claims 1 to 8, **characterized in that** the gas purging device consists of a carbon-free material.

10. A method for manufacturing crystalline bodies by directional solidification, in particular for manufacturing bodies consisting of multicrystalline silicon, in the device according to one of claims 1 to 9, in which
- a parent material (7a) for producing the crystalline bodies in the crucible (8) is melted with the formation of a melt (7b),
- the lower plunger surface(s) of the gas purging device is/are set at a distance to a surface of the melt (7b) or parent material (7a) that enables a removal of undesired material from the surface of the melt (7b) or parent material (7a) by supplying a scavenging gas via the gas purging device,
- the scavenging gas is supplied via the gas purging device to generate a gas flow over the surface of the melt (7b) or parent material (7a), and
- the melt (7b) is solidified from the bottom up during the supply of scavenging gas.

11. The method according to claim 10, wherein the gas flow is varied during directional solidification.

12. The method according to claim 10 or 11, wherein the distance between the surface of the melt (7b) and the lower plunger surface is varied during directional solidification.

13. The method according to claim 10 or 11, wherein the distance between the surface of the melt (7b) and the lower plunger surface is held constant during directional solidification.

14. The method according to one of claims 10 to 13, wherein the distance between the surface of the melt (7b) and the lower plunger surface as well as the gas flow are set in such a way as to give rise to a stream of gas for removing the undesired material from the surface of the melt (7b) over a gap between the plunger-shaped body/bodies (2) and the lateral wall of the crucible (8).

15. The method according to one of claims 10 to 14, wherein the distance between the surface of the melt (7b) and the lower plunger surface as well as the gas flow are set in such a way that the gas flow influences a flow rate in the melt (7b).

16. The method according to one of claims 10 to 15, wherein the distance between the surface of the melt (7b) and the lower plunger surface as well as the gas flow are set in such a way that the gas flow influences a degree of deflection of a liquid-solid phase boundary in the melt (7b).

## Revendications

1. Dispositif de fabrication de corps cristallins par solidification dirigée et qui comprend un four de fusion (11) équipé d'une cellule chauffante (12), dans lequel sont réalisés au moins une surface d'appui (13) pour un creuset de fusion (8) qui présente une paroi latérale et un fond et au moins un dispositif de balayage au gaz disposé au-dessus de la surface d'appui (13) et comportant une sortie de gaz tournée vers la surface d'appui (13),
**caractérisé en ce que**
la sortie de gaz est constituée par un ou plusieurs orifices pratiqués dans une surface de poinçon inférieure d'un corps en forme de poinçon (2) qui présente une géométrie adaptée à la forme intérieure du creuset de fusion (8) et permet une introduction au moins partielle du corps en forme de poinçon (2) dans le creuset de fusion (8) avec un écart latéral par rapport à la paroi latérale du creuset de fusion (8) et que
le dispositif de balayage au gaz et/ou la surface d'appui (13) sont disposés ou montés de manière à être mobiles dans un sens axial afin de permettre une modification d'un écart vertical entre la surface d'appui (13) et le corps en forme de poinçon (2).

2. Dispositif de fabrication de corps cristallins par solidification dirigée et qui comprend un four de fusion (11) équipé d'une cellule chauffante (12), dans lequel sont réalisés au moins une surface d'appui (13) pour un creuset de fusion (8) qui présente une paroi latérale et un fond et au moins un dispositif de balayage au gaz disposé au-dessus de la surface d'appui (13) et comportant une sortie de gaz tournée vers la surface d'appui (13),
**caractérisé en ce que**
la sortie de gaz est constituée par un ou plusieurs orifices pratiqués dans des surfaces de poinçon inférieures d'un groupe constitué de plusieurs corps en forme de poinçon (2) disposés côte à côte et qui présente une géométrie adaptée à la forme intérieure du creuset de fusion (8) et permet une introduction au moins partielle du groupe de corps en forme de poinçon (2) dans le creuset de fusion (8) avec un écart latéral par rapport à la paroi latérale du creuset de fusion (8) et que
le dispositif de balayage au gaz et/ou la surface d'appui (13) sont disposés ou montés de manière à être mobiles dans un sens axial afin de permettre une modification de l'écart vertical entre la surface d'appui (13) et les corps en forme de poinçon (2).

3. Dispositif selon la revendication 1,
**caractérisé en ce que**
le corps en forme de poinçon (2) présente une géométrie qui permet une introduction au moins partielle du corps en forme de poinçon (2) dans le creuset de fusion (8) avec un écart latéral par rapport à la paroi latérale identique de chaque côté.

4. Dispositif selon la revendication 1 ou 3,
**caractérisé en ce que**
le corps en forme de poinçon (2) présente, à distance de la surface inférieure du poinçon, une saillie latérale périphérique qui permet le recouvrement d'un bord supérieur du creuset de fusion (8).

5. Dispositif selon la revendication 2,
**caractérisé en ce que**
le groupe de corps en forme de poinçon (2) présente une géométrie qui permet une introduction au moins partielle du groupe de corps en forme de poinçon (2) dans le creuset de fusion (8) avec un écart latéral par rapport à la paroi latérale identique de chaque côté.

6. Dispositif selon la revendication 2 ou 5,
**caractérisé en ce que**
les corps en forme de poinçon (2) présentent, à distance de la surface inférieure du poinçon, une saillie latérale périphérique qui permet le recouvrement d'un bord supérieur du creuset de fusion (8).

7. Dispositif selon une des revendications 1 à 6,
**caractérisé en ce que**
la surface inférieure du poinçon a une conformation plane et est disposée parallèlement à la surface d'appui (13).

8. Dispositif selon une des revendications 1 à 7,
**caractérisé en ce que**
la géométrie du corps en forme de poinçon (2) ou du groupe de corps en forme de poinçon (2) est choisie de manière à ce que l'écart latéral par rapport à la paroi latérale du creuset de fusion (8) soit ≤ 1 cm.

9. Dispositif selon une des revendications 1 à 8,
**caractérisé en ce que**
le dispositif de balayage au gaz est composé d'un matériau exempt de carbone.

10. Procédé de fabrication de corps cristallins par solidification dirigée, en particulier de fabrication de corps en silicium multicristallin dans le dispositif selon une des revendications 1 à 9, dans lequel :
- un matériau initial (7a) destiné à la fabrication des corps cristallins est fondu dans le creuset de fusion (8) en formant une coulée (7b),
- la (les) surface (s) inférieure (s) du dispositif de balayage au gaz est(sont) positionnée(s) à une distance par rapport à une surface supérieure de la coulée (7b) ou du matériau initial (7a) qui permet une évacuation de matériau indésirable de la surface de la coulée (7b) ou du matériau initial (7a) par acheminement d'un gaz de balayage via le dispositif de balayage au gaz,
- le gaz de balayage est acheminé via le dispositif de balayage au gaz afin de créer un flux gazeux au-dessus de la surface de la coulée (7b) ou du matériau initial (7a) et
- la coulée (7b) se solidifie du bas vers le haut pendant l'acheminement du gaz de balayage.

11. Procédé selon la revendication 10,
dans lequel le flux gazeux varie pendant la solidification dirigée.

12. Procédé selon la revendication 10 ou 11,
dans lequel l'écart entre la surface de la coulée (7b) et la surface inférieure du poinçon varie pendant la solidification dirigée.

13. Procédé selon la revendication 10 ou 11,
dans lequel l'écart entre la surface de la coulée (7b) et la surface inférieure du poinçon est maintenue constante pendant la solidification dirigée.

14. Procédé selon une des revendications 10 à 13,
dans lequel l'écart entre la surface de la coulée (7b) et la surface inférieure du poinçon ainsi que le flux gazeux sont établis de manière à ce que s'installe un écoulement gazeux pour l'évacuation du matériau indésirable de la surface de la coulée (7b) par un intervalle entre le ou les corps en forme de poinçon (2) et la paroi latérale du creuset de fusion (8).

15. Procédé selon une des revendications 10 à 14, dans lequel l'écart entre la surface de la coulée (7b) et la surface inférieure du poinçon ainsi que le flux gazeux sont établis de manière à ce que le flux gazeux influe sur une vitesse d'écoulement dans la coulée (7b).

16. Procédé selon une des revendications 10 à 15, dans lequel l'écart entre la surface de la coulée (7b) et la surface inférieure du poinçon ainsi que le flux gazeux sont établis de manière à ce que le flux gazeux influe sur un degré d'inflexion d'une limite de phase liquide/solide dans la coulée (7b).
